# EUROPÄISCHE PATENTSCHRIFT

(11) **EP 2 754 215 B1**
(45) Veröffentlichungstag und Bekanntmachung des Hinweises auf die Patenterteilung: **02.08.2017**
(21) Anmeldenummer: 13702745.4
(22) Anmeldetag: 29.01.2013
(51) Int. Cl.: H02G 3/08, H02G 3/18, H02G 3/14

(54) **GEHÄUSEBAUSATZ FÜR ELEKTRISCHE EINRICHTUNGEN, INSBESONDERE STECKVORRICHTUNGEN UND SICHERUNGEN UMFASSEND**
HOUSING CONSTRUCTION SET FOR ELECTRICAL DEVICES, IN PARTICULAR COMPRISING PLUG APPARATUSES AND SAFETY MEANS
ENSEMBLE BOÎTIER POUR DISPOSITIFS ÉLECTRIQUES COMPRENANT EN PARTICULIER DES DISPOSITIFS DE CONNEXION ET DES FUSIBLES

(30) Priorität: 03.02.2012 DE 202012001075 U
(43) Veröffentlichungstag der Anmeldung: 16.07.2014
(60) Teilanmeldung: 17177970.5
(73) Patentinhaber: Bals Elektrotechnik GmbH & Co. Kg, 57399 Kirchhundem-Albaum (DE)
(72) Erfinder: RAMM, Andreas, 57399 Kirchhundem (DE); BANKSTAHL, Mareike, 57399 Kirchhundem (DE)
(74) Vertreter: Bill, Burkart Hartmut
(86) Internationale Anmeldenummer: PCT/EP2013/000253
(87) Internationale Veröffentlichungsnummer: WO 2013/113490

(56) Entgegenhaltungen:
- WO-A1-98/48489
- DE-A1- 3 817 869
- DE-B3- 10 310 630

## Beschreibung

Die Erfindung betrifft einen Gehäusebausatz für elektrische Einrichtungen, welche z.B. Steckvorrichtungen und Sicherungen umfassen. Bekannte Steckvorrichtungen- bzw. Steckdosen-Kombinationen enthalten ein Gehäuse, das an seiner Oberseite Aussparungen für den Einbau von Steckvorrichtungen bzw. Steckdosen aufweist und zum Beispiel für die Befestigung an einer Wand eingerichtet ist. Falls in dem Gehäuse auch elektrische Sicherungen, wie z.B. Sicherungsautomaten, Fehlerstromschutzschalter, Schmelzsicherungen usw., untergebracht werden sollen, hat es zusätzlich eine größere rechteckige Aussparung für den Einbau eines schwenkbaren transparenten Fensters.

Ferner sind Bausätze für verschiedene Steckvorrichtungen-Kombination z.B. aus der DE 103 10 630 B3 bekannt.

Demgemäß umfasst ein dort offenbarter Bausatz ein Gehäuse mit mindestens einer Einbauöffnung, eine Einbauplatte, an welcher mindestens eine Steckvorrichtung montiert werden kann und eine als Einbaufenster mit zumindest teilweise transparentem Material ausgebildete Einbauplatte, wobei sowohl die Einbauplatte, an welcher mindestens eine Steckvorrichtung montiert werden kann, als auch die als Einbaufenster ausgebildete Einbauplatte für eine Montage in der Einbauöffnung des Gehäuses eingerichtet sind.

Als Vorteil wird aufgezeigt, dass hierdurch für alle gewünschten Kombinationen auf gleichartige Grundmodelle des Gehäuses zurückgegriffen werden kann und für die individuelle Bestückung mit Steckvorrichtungen sowie mit Fenstern nunmehr die in Frage kommenden Einbauplatten hergestellt und bevorratet werden müssen, wobei ein Fenster in jeder Einbauöffnung des Gehäuses vorgesehen werden kann, in welcher auch Steckvorrichtungen montiert werden können.

Ein weiterer, in der DE 103 10 630 B3 beschriebener Bausatz für Steckvorrichtungen-Kombinationen umfasst zwei verschieden ausgestaltete Gehäuse, die jeweils mindestens eine gleichartige Einbauöffnung aufweisen sowie eine Einbauplatte, an der mindestens eine Steckvorrichtung montiert werden kann, und die für eine Montage in der Einbauöffnung des Gehäuses eingerichtet ist.

Für diesen Bausatz wird in der DE 103 10 630 B3 als Vorteil aufgezeigt, dass bei geringem Produktionsvorlauf eine einfache und flexible Herstellung sehr unterschiedlicher Steckvorrichtungen-Kombinationen mit wenigen bis vielen Steckvorrichtungen möglich wird, wobei trotz Verwendung unterschiedlicher Gehäusegrößen auf dieselben Einbauplatten zurückgegriffen werden kann, da die Einbauöffnungen in den Gehäusen jeweils gleichartig sind.

Zwar ermöglicht der Gegenstand der DE 103 10 630 B3 somit eine sehr flexible und kostengünstige Herstellung von Steckvorrichtungen-Kombinationen, da grundsätzlich Wahlfreiheit darin besteht, in ein und derselben Einbauöffnung entweder eine "Steckvorrichtungen-Einbauplatte" oder eine "Einbaufenster-Einbauplatte" zu montieren, sowie ein und dieselbe Einbauplatte entweder in die "Einbauöffnung des ersten Gehäuses" oder in die "gleichartige Einbauöffnung des anderen Gehäuses" zu montieren.

In Bezug auf jeglichen anwendungsspezifischen Einsatz solcher Steckvorrichtungen-Kombinationen entstehen hierdurch jedoch höchste Anforderungen an die eigentliche Montage, insbesondere auch in Bezug auf jegliche Vorinstallation elektrischer Einrichtungen in dem jeweiligen Gehäuse. Da innerhalb eines Bausatzes für ein einzelnes Gehäuse somit für eine Steckvorrichtungsmontage geeignete Einbauplatten und als Fenster ausgebildete Einbauplatten enthalten sind, die in ein und dieselbe Gehäuseöffnung passen bzw. innerhalb eines Bausatzes für wenigstens zwei verschieden ausgestaltete Gehäuse Einbauplatten enthalten sind, die jeweils in eine Gehäuseöffnung des einen Gehäuses oder in eine gleichartige Gehäuseöffnung des anderen, verschieden ausgestalteten Gehäuses passen, ist bei einer Montage der Steckvorrichtungen-Kombinationen im Wesentlichen keinerlei technische Sicherheit mehr durch die Komponenten selbst gegeben, dass also z.B. Vorinstallationen an korrekten Positionen innerhalb des Gehäuses eingebaut werden, diverse Sicherheitsmaßnahmen, wie z.B. Mindestabstände, eingehalten werden und für elektrische Einrichtungen innerhalb des Gehäuses auch lediglich die Einbauplatten mit Eignung von für diese elektrische Einrichtungen vorbestimmten Steckvorrichtungen verwendet werden.

Eine wesentliche Aufgabe der Erfindung ist es daher einen Gehäusebausatz für elektrische Einrichtungen wie z.B. für Steckvorrichtungen und Sicherungen bereitzustellen, der auch eine flexible Herstellung von Kombinationen elektrischer Einrichtungen in einem Gehäuse ermöglicht, jedoch zusätzlich technische Sicherheitselemente bietet, die bei der Montage zum Einsatz kommen.

Die erfindungsgemäße Lösung ist durch einen Gegenstand mit den Merkmalen nach Anspruch 1 gegeben. Bevorzugte Ausführungsformen und Weiterbildungen sind Gegenstand der Unteransprüche.

Demgemäß stellt die Erfindung einen Gehäusebausatz für elektrische Einrichtungen, insbesondere für elektrische Einrichtungen, welche wenigstens eine Steckvorrichtung und/oder eine Sicherung umfassen, bereit, der einen Gehäuse-Grundkörper mit einer Anzahl von Einbauöffnungen und eine Anzahl von Einbauplatten umfasst, wobei wenigstens eine Einbauplatte zur Eignung der Montage wenigstens einer Steckvorrichtung ausgebildet ist und/oder wenigstens eine Einbauplatte wenigstens teilweise aus transparentem Material ist und/oder wenigstens eine Einbauplatte vollständig geschlossen ist und/oder wobei wenigstens eine Einbauplatte Lüftungsdurchgänge besitzt und/oder wenigstens eine Einbauplatte einen Rahmen aufweist, an welchem mittels eines Scharniergelenkes eine Betätigungsklappe schwenkbeweglich angeordnet ist. An jeder Einbauöffnung ist ein erstes Codierungsmittel ausgebildet und an jeder Einbauplatte ein zweites Codierungsmittel, wobei jedes erste Codierungsmittel einer Einbauöffnung innerhalb des Gehäusebausatzes eine einzigartige erste Codierung und jedes zweite Codierungsmittel einer Einbauplatte innerhalb des Gehäusebausatzes eine einzigartige zweite Codierung besitzt, derart, dass innerhalb des Gehäusebausatzes jedes zweite Codierungsmittel einer Einbauplatte zu maximal einem ersten Codierungsmittel einer Einbauöffnung komplementär ausgebildet ist, und zumindest innerhalb des Gehäusebausatzes jedes zweite Codierungsmittel einer Einbauplatte, welche wenigstens teilweise aus transparentem Material ist, zu einem ersten Codierungsmittel einer anderen Einbauöffnung komplementär ausgebildet ist, als jedes zweite Codierungsmittel einer Einbauplatte, welche zur Eignung der Montage wenigstens einer Steckvorrichtung ausgebildet ist.

Ein wesentlicher Vorteil ist somit, dass eine willkürliche und damit auch falsche bis gefährliche Anordnung wenigstens der Einbauplatten, die für die Montage von Steckvorrichtungen geeignet sind und der als Fenster ausgebildeten Einbauplatten z.B. für dahinterliegende Sicherungen, wie z.B. Sicherungsautomaten ausgeschlossen ist. Folglich ist beim Montieren eines erfindungsgemäßen Gehäusebausatzes eine nicht beabsichtigte, falsche oder gefährliche Anordnung auch der hinter diesen Einbauplatten angeordneten Einrichtungen auf einfache Weise bereits im Vorfeld erkennbar und damit auf einfache Weise ausschließbar.

Je nach spezifischem Kundenwunsch kann jedoch weiterhin die flexible Bereitstellung eines individuell zusammengestellten Gehäusebausatzes gewährleistet werden, der allerdings aufgrund der als technische Sicherheitselemente wirkenden Kodierungsmittel lediglich in der vorbestimmten Weise montierbar ist.

Die flexible Herstellung von Kombinationen elektrischer Einrichtungen innerhalb einem Gehäuse ist somit weiterhin ermöglicht.

Eine besonders bevorzugte Ausführungsform sieht ferner vor, dass bei wenigstens einer Einbauplatte, die Rahmen aufweist, an welchem eine Betätigungsklappe schwenkbeweglich angeordnet ist, der Rahmen einen mit der Betätigungsklappe zusammenwirkenden Verschlussmechanismus und einen Sperrmechanismus besitzt, wobei der Sperrmechanismus eine Aktivierung des Verschlussmechanismus verhindert, solange die Betätigungsklappe geöffnet ist.

Ein wesentlicher Vorteil hierbei ist, dass eine Betätigungsklappe erst durch bewusstes Schließen derselben auch verschlossen wird, und zwar durch einen Verschlussmechanismus, welcher ein ungewolltes Verschließen der Betätigungsklappe verhindert. Auch hierdurch wird folglich die Montage wesentlich vereinfacht. Vorzugsweise besitzt die Betätigungsklappe ferner eine Dichtung und der Sperrmechanismus ist ausgebildet, beim Verschwenken der Betätigungsklappe zum Schließen dieser Betätigungsklappe den Verschlussmechanismus zu aktivieren, so dass dieser im daraufhin aktivierten Zustand die Betätigungsklappe beim weiteren Schließen der Betätigungsklappe auf die Dichtung drückt.

Besonders bevorzugt ist der Sperrmechanismus im geschlossenen Zustand der Betätigungsklappe, und zwar zum Öffnen der Betätigungsklappe, aktivierbar.

Die ersten und zweiten Kodierungsmittel sind in besonders einfacher Weise bereits durch unterschiedliche Größen und/oder Formen der Einbauöffnungen bzw. Einbauplatten bereitstellbar, wobei besonders bevorzugt die ersten und zweiten Kodierungsmittel jeweils durch einzigartige Anordnungen stiftartiger Verlängerungen oder Aufnahmen zur Aufnahme von stiftartigen Verlängerungen bereitgestellt sind, so dass bei alleiniger Anwendung der letztgenannten Möglichkeit zur einzigartigen Kodierung auch auf grundsätzlich stets wiederkehrenden Grundkomponenten bei der Herstellung der Gehäusegrundkörper und der Einbauplatten zurückgegriffen werden kann. So können zur einzigartigen Anordnung von stiftartigen Verlängerungen beispielsweise erst im letzten Herstellungsschritt des Gehäusebausatzes bestimmte, zunächst provisorisch angeordnete stiftartige Verlängerungen zur einzigartigen Kodierung entfernt werden.

Weitere Vorteile und Merkmale der vorliegenden Erfindung ergeben sich aus der nachfolgenden beispielhaften Beschreibung einiger Ausführungsformen unter Bezugnahme auf die beigefügten Zeichnungen. In den Zeichnungen zeigen:
- Fig. 1a) bis d): jeweils ein Gehäuseoberteil von verschieden ausgestalteten Gehäusegrundkörpern mit daran ausgebildeten Einbauöffnungen und einzigartigen ersten Kodierungsmittel;
- Fig. 2: fünf verschiedene beispielhafte Einbauplatten, welche zur Ausbildung einzigartiger zweiter Kodierungsmittel geeignet sind; und
- Fig. 3: verschiedene, teilweise geschnittene Ansichten einer besonders bevorzugten Einbauplatte mit einem Rahmen, in welchem eine Betätigungsklappe schwenkbeweglich sowie ein Sperrmechanismus und ein Verschlussmechanismus angeordnet ist.

Nachfolgend wird an beispielhaften Ausführungsformen, im Rahmen der Erfindung liegende zusammenstellbare Gehäusebausätze für elektrische Einrichtungen, insbesondere für elektrische Einrichtungen, welche wenigstens eine Steckvorrichtung und/oder eine Sicherung, wie z.B. einen Sicherungsautomaten, Fehlerstromschutzschalter, Schmelzsicherungen usw., umfassen, beschrieben.

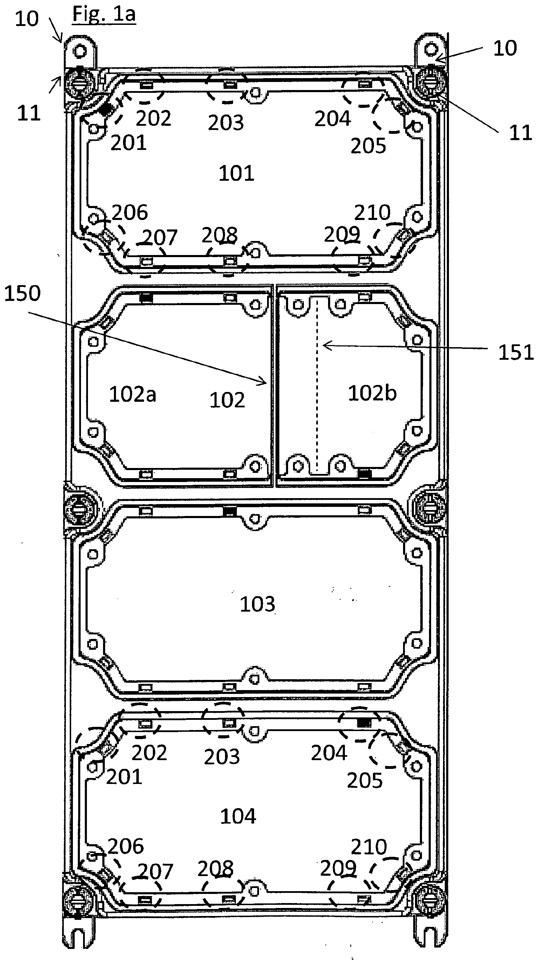

Solche Gehäusebausätze enthalten einen Gehäusegrundkörper, der ein- oder mehrteilig aufgebaut sein kann und beispielsweise ein Gehäuseoberteil und ein Gehäuseunterteil besitzt, welche reversibel zusammen verbindbar sind. Bei der nachfolgenden Bezugnahme zunächst auf die Figur 1a bis 1d wird der Einfachheit halber von einem mehrteiligem Gehäusegrundkörper ausgegangen, wobei die Figuren 1a bis 1d jeweilige Gehäuseoberteile eines solchen Gehäusegrundkörpers zeigen, die mit jeweils einem Gehäuseunterteil (nicht dargestellt) reversibel verbindbar sind. Ein solches Gehäuseunterteil kann kastenartig aufgebaut sein, beispielsweise ähnlich zu Gehäuseunterteilen gemäß DE 103 10 630 B3. Es sei jedoch darauf hingewiesen, dass je nach Art der unterzubringenden elektrischen Einrichtungen auch ein Gehäuseunterteil mit wenigstens einer Einbauöffnung im Rahmen der Erfindung ausgebildet sein kann und/oder der Grundkörper auch einteilig ausgebildet sein kann.

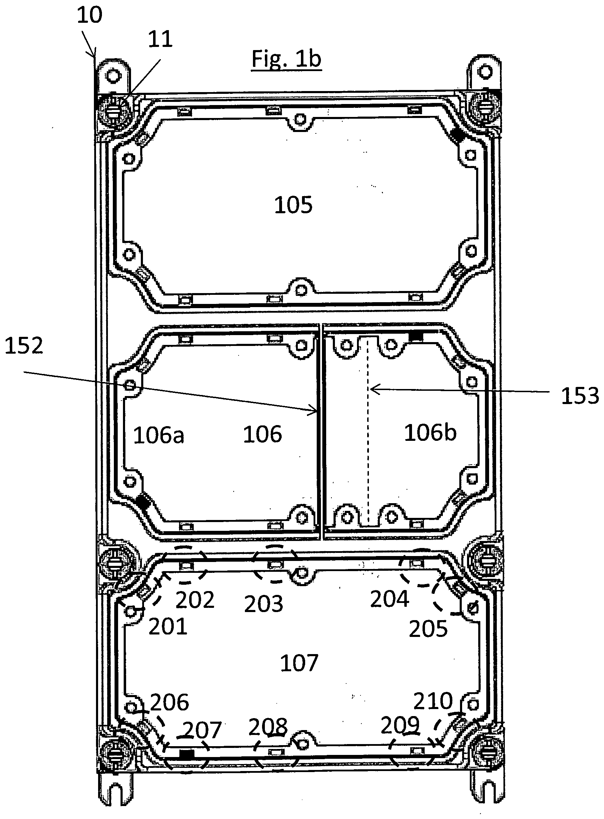

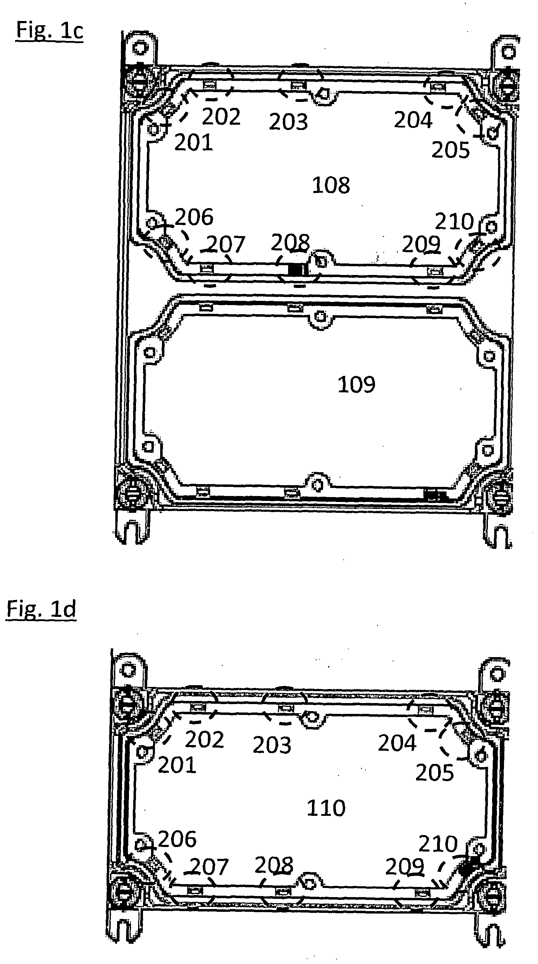

Die Gehäuseoberteile gemäß Figuren 1a bis 1d umfassen neben Verbindungsmitteln 10, 11 zum Verbinden mit einem geeigneten Gehäuseunterteil jeweils eine Anzahl von Einbauöffnungen 101 bis 104 (Figur 1a), 105 bis 107 (Figur 1b), 108 und 109 (Figur c) sowie 110 (Figur 1d).

Zur nochmaligen Erweiterung des Satzes von Einbauöffnungen bei der jeweiligen Herstellung und Zusammenstellung eines Gehäusebausatzes sind die Einbauöffnungen 102a und 102b des Gehäuseoberteils eines auf Fig. 1a basierenden Bausatzes sowie die Einbauöffnungen 106a und 106b des Gehäuseoberteils eines auf Fig. 1b basierenden Bausatzes durch einen zusätzlichen, zweckmäßig dauerhaft zuvor am Gehäuseoberteil angebrachten, insbesondere angespritzten Steg 150 bzw. 152 voneinander getrennt. Dementsprechend kann bei einem ansonsten auf Fig. 1a oder auf Fig. 1b basierenden Bausatz alternativ auch das vorherige dauerhafte Anbringen, insbesondere Anspritzen, des Steges 150 bzw. 152 am Gehäuseoberteil unterbleiben, so dass anstelle der Einbauöffnungen 102a und 102b bzw. 106a und 106b jeweils eine Einbauöffnung 102 bzw. 106 vorhanden ist. Dementsprechend kann ferner bei einem ansonsten auf Fig. 1a oder auf Fig. 1b basierenden Bausatz alternativ der Steg 150 bzw. 152 parallel versetzt, an anderer Stelle, z.B. an der mit 151 oder 153 gekennzeichneten gestrichelten Linie am Gehäuseoberteil zuvor dauerhaft angebracht, insbesondere angespritzt sein, so dass anstelle der dargestellten Größe der Einbauöffnungen 102a, 106a, 102b und 106b die Einbauöffnungen 102a oder 106a vergrößert bzw. die Einbauöffnungen 102b oder 106b verkleinert sind. Je nach Kundenvorgabe kann folglich ein höchst individueller Gehäusebausatz basierend auf einem oder auch auf verschieden ausgestalteten Gehäuse-Grundkörpern mit entsprechenden Einbauöffnungen mit jeweils einzigartigen Kodierungsmittel und mit gleichermaßen jeweils einzigartige zweite Kodierungsmittel besitzenden Einbauplatten zusammengestellt werden.

Da, wie aus den Figuren 1a bis 1d ersichtlich, die Einbauöffnungen 101, 103, 104, 105, 107, 108, 109, 110 sowie, sofern das vorherige dauerhafte Anbringen des Steges 150 zwischen den Einbauöffnungen 102a und 102b bzw. des Steges 152 zwischen den Einbauöffnungen 106a und 106b unterblieben ist, auch die Einbauöffnungen 102 und 106 jeweils die gleiche Größe und Form besitzen, ist im vorliegenden Beispiel an jeder der Einbauöffnungen als besonders bevorzugtes erstes Kodierungsmittel jeweils eine Anzahl von an vorbestimmten Positionen angeordneten Aufnahmen zur Aufnahme von stiftartigen Verlängerungen ausgebildet, die in ihrer Anordnung jeweils einzigartig innerhalb eines Gehäusebausatzes nach der Erfindung ist.

So besitzt die Einbauöffnung 101 beispielsweise Aufnahmen zur Aufnahme von stiftartigen Verlängerungen an den vorbestimmten Positionen 202, 203, 204, 205, 206, 207, 208, 209 und 210. An einer vorbestimmten Position 201 besitzt die Einbauöffnung 101 hingegen keine Aufnahme, sondern ist dort vielmehr zur Aufnahme von solchen stiftartigen Verlängerungen nicht geeignet.

Die Einbauöffnung 102a besitzt Aufnahmen an den in Bezug auf die Einbauöffnung 101 entsprechenden gleichen vorbestimmten Positionen 201, 203, 206, 207 und 208. An der in Bezug auf die Einbauöffnung 101 entsprechenden gleichen vorbestimmten Position 202 besitzt die Einbauöffnung 102a hingegen keine Aufnahme, sondern ist dort vielmehr zur Aufnahme von solchen stiftartigen Verlängerungen nicht geeignet.

Die Einbauöffnung 102b besitzt Aufnahmen an den in Bezug auf die Einbauöffnung 101 entsprechenden gleichen vorbestimmten Positionen 204, 205, und 210. An der in Bezug auf die Einbauöffnung 101 entsprechenden gleichen vorbestimmten Position 209 besitzt die Einbauöffnung 102b hingegen keine Aufnahme, sondern ist dort vielmehr zur Aufnahme von solchen stiftartigen Verlängerungen nicht geeignet.

Sind in Abwandlung die Einbauöffnungen 102a und 102b nicht durch den Steg 150 voneinander getrennt, sondern bilden gemeinsam eine einzige Einbauöffnung 102, besitzt eine solche Einbauöffnung Aufnahmen zur Aufnahme von stiftartigen Verlängerungen an den in Bezug auf die Einbauöffnung 101 entsprechenden gleichen vorbestimmten Positionen 201, 203, 204, 205, 206, 207, 208 und 210, hingegen an den vorbestimmten Positionen 202 und 209 keine Aufnahmen, sondern ist dort vielmehr zur Aufnahme von solchen stiftartigen Verlängerungen nicht geeignet.

Die Einbauöffnung 103 besitzt an der in Bezug auf die Einbauöffnung 101 entsprechenden gleichen vorbestimmten Position 203 keine Aufnahme, sondern ist dort vielmehr zur Aufnahme von solchen stiftartigen Verlängerungen nicht geeignet. An allen anderen in Bezug auf die Einbauöffnung 101 gleichen vorbestimmten Positionen besitzt die Einbauöffnung 103 eine Aufnahme zur Aufnahme von stiftartigen Verlängerungen.

Die Einbauöffnung 104 besitzt an der in Bezug auf die Einbauöffnung 101 entsprechenden gleichen vorbestimmten Position 204 keine Aufnahme, sondern ist dort vielmehr zur Aufnahme von solchen stiftartigen Verlängerungen nicht geeignet. An allen anderen in Bezug auf die Einbauöffnung 101 gleichen vorbestimmten Positionen besitzt die Einbauöffnung 104 eine Aufnahme zur Aufnahme von stiftartigen Verlängerungen.

Die Einbauöffnung 105 besitzt an der in Bezug auf die Einbauöffnung 101 entsprechenden gleichen vorbestimmten Position 205 keine Aufnahme, sondern ist dort vielmehr zur Aufnahme von solchen stiftartigen Verlängerungen nicht geeignet. An allen anderen in Bezug auf die Einbauöffnung 101 gleichen vorbestimmten Positionen besitzt die Einbauöffnung 105 eine Aufnahme zur Aufnahme von stiftartigen Verlängerungen.

Auch die Einbauöffnungen 106a, 106b, 107, 108, 109 und 110 besitzen jeweils an der in Bezug auf die Einbauöffnung 101 gleichen vorbestimmten Position 206, 204, 207, 208, 209 bzw. 210 keine Aufnahme, sondern sind dort vielmehr zur Aufnahme von solchen stiftartigen Verlängerungen nicht geeignet. An allen anderen in Bezug auf die Einbauöffnung 101 gleichen vorbestimmten Positionen besitzen die Einbauöffnungen 106a, 106b, 107, 108, 109 und 110 jeweils eine Aufnahme zur Aufnahme von stiftartigen Verlängerungen.

Sind in Abwandlung die Einbauöffnungen 106a und 106b nicht durch den Steg 152 voneinander getrennt, sondern bilden gemeinsam eine einzige Einbauöffnung 106, besitzt eine solche Einbauöffnung an der in Bezug auf die Einbauöffnung 101 gleichen vorbestimmten Positionen 206 und 204 keine Aufnahme, sondern ist dort vielmehr zur Aufnahme von solchen stiftartigen Verlängerungen nicht geeignet. An allen anderen in Bezug auf die Einbauöffnungen 101 gleichen vorbestimmten Positionen besitzt die Einbauöffnung 106 jedoch eine Aufnahme zur Aufnahme von stiftartigen Verlängerungen.

Folglich ist durch das erste Kodierungsmittel auch bei gleichgroßen, aneinander gereihten Einbauöffnungen innerhalb eines Gebäudebausatzes, welcher lediglich einen Gehäuse-Grundkörper beinhaltet, also z.B. basierend auf Fig. 1a, Fig. 1b, Fig. 1c oder Fig. 1d stets sichergestellt, dass jedes erste Kodierungsmittel innerhalb dieses Gebäudebausatzes mit nur einem Gehäusegrundkörper bereits einzigartig ist.

Folglich ist jedoch durch das erste Kodierungsmittel auch innerhalb eines Gebäudebausatzes mit verschieden ausgestalteten Gehäuse-Grundkörpern, zumindest basierend auf Fig. 1a und Fig. 1d oder basierend auf Fig. 1b, Fig. 1c und/oder Fig. 1d stets sichergestellt, dass jedes erste Kodierungsmittel dann innerhalb dieses Gebäudebausatzes mit wenigstens zwei verschieden ausgestalteten Gehäuse-Grundkörpern einzigartig ist. Ist anstelle der Einbauöffnungen 102a und 102b bzw. 106a und 106b jeweils eine Einbauöffnung 102 bzw. 106 vorhanden, ist innerhalb eines Gebäudebausatzes mit verschieden ausgestalteten Gehäuse-Grundkörpern, basierend auf Fig. 1a, Fig. 1b, Fig. 1c und/oder Fig. 1d stets sichergestellt, dass jedes erste Kodierungsmittel dann innerhalb dieses Gebäudebausatzes mit verschieden ausgestalteten Gehäuse-Grundkörpern einzigartig ist.

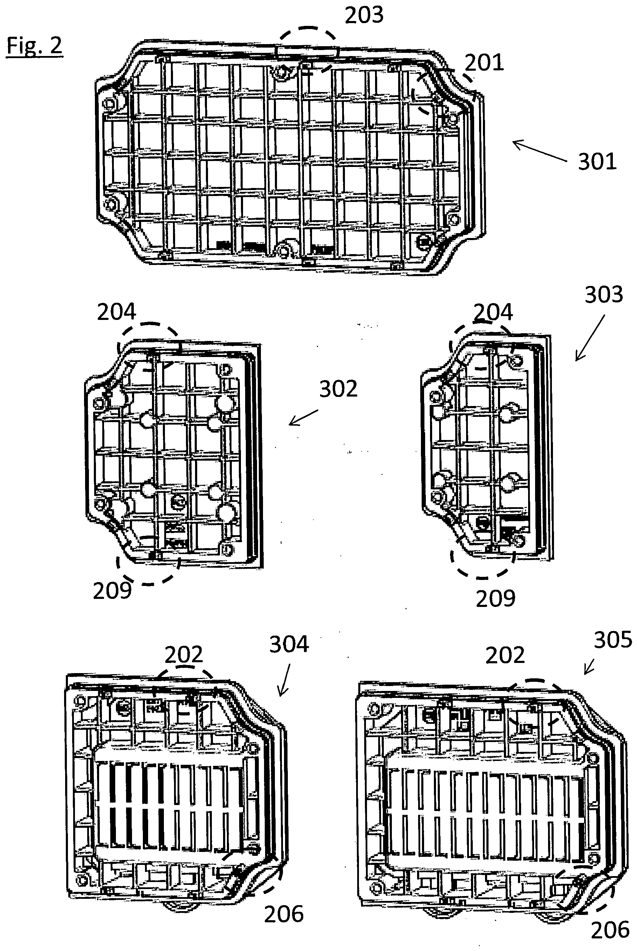

Figur 2 zeigt eine Anzahl von Einbauplatten, die zur Zusammenstellung eines Gehäusebausatzes im Rahmen der Erfindung geeignet sind, wobei der Einfachheit halber lediglich verschlossene Einbauplatten 301, 302 und 303 und mit Lüftungsdurchgängen versehene Einbauplatten 304 und 305 gezeigt sind. Es sei jedoch darauf hingewiesen, dass in gleicher Weise auch andersartige Einbauplatten für einen individuell zusammengestellten Gehäusebausatz im Rahmen der Erfindung vorgesehen sind, bevorzugt Einbauplatten, die zur Eignung der Montage wenigstens einer Steckvorrichtung (z.B. Stecker oder Steckdose) ausgebildet sind, wie dies z.B. auch in der DE 103 10 630 B3 beschrieben ist, Einbauplatten, die wenigstens teilweise aus transparentem Material sind und/oder Einbauplatten, die wenigstens einen Rahmen aufweisen, an welchem mittels eines Scharniergelenkes eine Betätigungsklappe schwenkbeweglich angeordnet ist.

Die Einbauplatten 301, 302, 303, 304 und 305 besitzen jeweils an in Bezug auf die Einbauöffnungen gemäß Fign. 1a bis 1d gleichen vorbestimmten Positionen 201, 202, 203, 204, 205, 206, 207, 208, 209 oder 210 stiftartige Verlängerungen.

Innerhalb eines erfindungsgemäß zusammengestellten Gehäusebausatz, bei welchem z.B. eine Einbauplatte 301 lediglich in die Einbauöffnung 101 korrekt montierbar ist, ist folglich an der Position 201 zur einzigartigen Kodierung die dortige stiftartige Verlängerung entfernt und die übrigen Verlängerungen verbleiben zweckgebunden als dauerhafte stiftartige Verlängerungen.
Soll z.B. innerhalb desselben erfindungsgemäß zusammengestellten Gehäusebausatz z.B. ferner eine weitere Einbauplatte 301 lediglich in die Einbauöffnung 103 korrekt montierbar sein, ist bei dieser weiteren Einbauplatte 301 folglich an der Position 203 zur einzigartigen Kodierung die dortige stiftartige Verlängerung entfernt und die übrigen Verlängerungen verbleiben zweckgebunden als dauerhafte stiftartige Verlängerungen.

In einem erfindungsgemäß zusammengestellten Gehäusebausatz, bei welchem z.B. lediglich die Einbauplatte 302 in die Einbauöffnung 102b korrekt montierbar ist, ist folglich an der Position 209 zur einzigartigen Kodierung die dortige stiftartige Verlängerung entfernt und die übrigen Verlängerungen verbleiben zweckgebunden und dauerhaft. Soll hingegen eine in einem erfindungsgemäß zusammengestellten Gehäusebausatz enthaltene, auf der Einbauplatte 302 basierende Einbauplatte lediglich in die Einbauöffnung 106b montierbar sein, ist folglich an der Position 204 zur einzigartigen Kodierung die dortige stiftartige Verlängerung entfernt und die übrigen Verlängerungen verbleiben zweckgebunden als dauerhafte stiftartige Verlängerungen.

Ist bei einem ansonsten auf Fig. 1a basierenden Bausatz jedoch alternativ der Steg 150 parallel an der mit 151 gekennzeichneten gestrichelten Linie am Gehäuseoberteil zuvor dauerhaft angebracht, und soll lediglich die Einbauplatte 303 in die somit verkleinerte Einbauöffnung 102b korrekt montierbar sein, ist somit in entsprechender Weise an der Einbauplatte 303 an der Position 209 zur einzigartigen Kodierung die dortige stiftartige Verlängerung entfernt und die übrigen Verlängerungen verbleiben zweckgebunden und dauerhaft. In entsprechender Weise ist bei einem ansonsten auf Fig. 1b basierenden Bausatz, bei dem jedoch alternativ der Steg 152 parallel an der mit 153 gekennzeichneten gestrichelten Linie am Gehäuseoberteil zuvor dauerhaft angebracht ist, bei einer auf der Einbauplatte 303 basierenden Einbauplatte, welche lediglich in diese verkleinerte Einbauöffnung 106b montierbar sein soll, folglich an der Position 204 zur einzigartigen Kodierung die dortige stiftartige Verlängerung entfernt und die übrigen Verlängerungen verbleiben zweckgebunden als dauerhafte stiftartige Verlängerungen.

Ist ferner innerhalb eines erfindungsgemäß zusammengestellten Gehäusebausatzes z.B. lediglich die Einbauplatte 304 lediglich in die Einbauöffnung 102a montierbar, ist folglich an der Position 202 zur einzigartigen Kodierung die dortige stiftartige Verlängerung entfernt und die übrigen Verlängerungen verbleiben zweckgebunden als dauerhafte stiftartige Verlängerungen. Soll eine auf der Einbauplatte 304 basierende Einbauplatte hingegen lediglich in die Einbauöffnung 106a montierbar sein, ist folglich an der Position 206 zur einzigartigen Kodierung die dortige stiftartige Verlängerung entfernt und die übrigen Verlängerungen verbleiben zweckgebunden als dauerhafte stiftartige Verlängerungen.

Ist bei einem ansonsten auf Fig. 1a basierenden Bausatz jedoch alternativ der Steg 150 parallel an der mit 151 gekennzeichneten gestrichelten Linie am Gehäuseoberteil zuvor dauerhaft angebracht, und soll lediglich die Einbauplatte 305 in die somit vergrößerte Einbauöffnung 102a korrekt montierbar sein, ist somit in entsprechender Weise an der Einbauplatte 305 an der Position 202 zur einzigartigen Kodierung die dortige stiftartige Verlängerung entfernt und die übrigen Verlängerungen verbleiben zweckgebunden und dauerhaft. In entsprechender Weise ist bei einem ansonsten auf Fig. 1b basierenden Bausatz, bei dem jedoch alternativ der Steg 152 parallel an der mit 153 gekennzeichneten gestrichelten Linie am Gehäuseoberteil zuvor dauerhaft angebracht ist, bei einer auf der Einbauplatte 305 basierenden Einbauplatte, welche lediglich in diese vergrößerte Einbauöffnung 106a montierbar sein soll, folglich an der Position 206 zur einzigartigen Kodierung die dortige stiftartige Verlängerung entfernt und die übrigen Verlängerungen verbleiben zweckgebunden als dauerhafte stiftartige Verlängerungen.

Dem Fachmann ist aufgrund vorstehender, unter Bezugnahme auf die Fig. 2 beschriebenen Möglichkeiten offensichtlich, dass hierdurch folglich innerhalb eines erfindungsgemäßen Gehäusebausatzes jeweils Einbauplatten zusammenstellbar sind, die innerhalb des Gehäusebausatzes jeweils ein zweites einzigartiges Kodierungsmittel besitzen, welches in Zusammenwirkung mit den ersten Kodierungsmitteln sichergestellt, dass innerhalb des erfindungsgemäß zusammengestellten Gehäusebausatzes jedes zweite Codierungsmittel einer Einbauplatte zu maximal einem ersten Codierungsmittel einer Einbauöffnung komplementär ausgebildet ist, und, dass zumindest innerhalb eines Gehäusebausatzes jedes zweite Codierungsmittel einer Einbauplatte, welche wenigstens teilweise aus transparentem Material ist, zu einem ersten Codierungsmittel einer anderen Einbauöffnung komplementär ausgebildet ist, als jedes zweite Codierungsmittel einer Einbauplatte, welche zur Eignung der Montage wenigstens einer Steckvorrichtung ausgebildet ist.

Ferner sind auf einfache Weise Gehäusebausätze ermöglicht, innerhalb welchen jedes erste Codierungsmittel einer Einbauplatte zu maximal einem zweiten Codierungsmittel einer Einbauöffnung komplementär ausgebildet ist, so dass innerhalb des Gehäusebausatzes in jede der Anzahl der Einbauöffnungen nur eine einzige Einbauplatte aus der Anzahl der Einbauplatten montierbar ist.

Folglich kann dies innerhalb eines Gebäudebausatzes, welcher lediglich einen Gehäuse-Grundkörper beinhaltet, also z.B. basierend auf Fig. 1a, Fig. 1b, Fig. 1c oder Fig. 1d stets sichergestellt werden, dass innerhalb des Gehäusebausatzes in jede der Anzahl der Einbauöffnungen nur eine einzige Einbauplatte aus der Anzahl der Einbauplatten montierbar ist.

Folglich kann auch innerhalb eines Gebäudebausatzes mit verschieden ausgestalteten Gehäuse-Grundkörpern, zumindest basierend auf Fig. 1a und Fig. 1d oder basierend auf Fig. 1b, Fig. 1c und/oder Fig. 1d stets sichergestellt werden, dass jedes zweite Codierungsmittel einer Einbauplatte innerhalb des Gehäusebausatzes zu maximal einem ersten Codierungsmittel einer Einbauöffnung komplementär ausgebildet ist, so dass innerhalb des Gehäusebausatzes jede der Anzahl der Einbauplatten nur in eine einzige Einbauöffnung montierbar ist.

Ist anstelle von getrennten Einbauöffnungen 102a und 102b bzw. 106a und 106b jeweils nur eine Einbauöffnung 102 bzw. 106 vorhanden, kann innerhalb eines Gebäudebausatzes mit verschieden ausgestalteten Gehäuse-Grundkörpern, basierend auf Fig. 1a, Fig. 1b, Fig. 1c und/oder Fig. 1d stets sichergestellt werden, dass jedes zweite Codierungsmittel einer Einbauplatte innerhalb des Gehäusebausatzes zu maximal einem ersten Codierungsmittel einer Einbauöffnung komplementär ausgebildet ist, so dass innerhalb des Gehäusebausatzes jede der Anzahl der Einbauplatten nur in eine einzige Einbauöffnung montierbar ist.

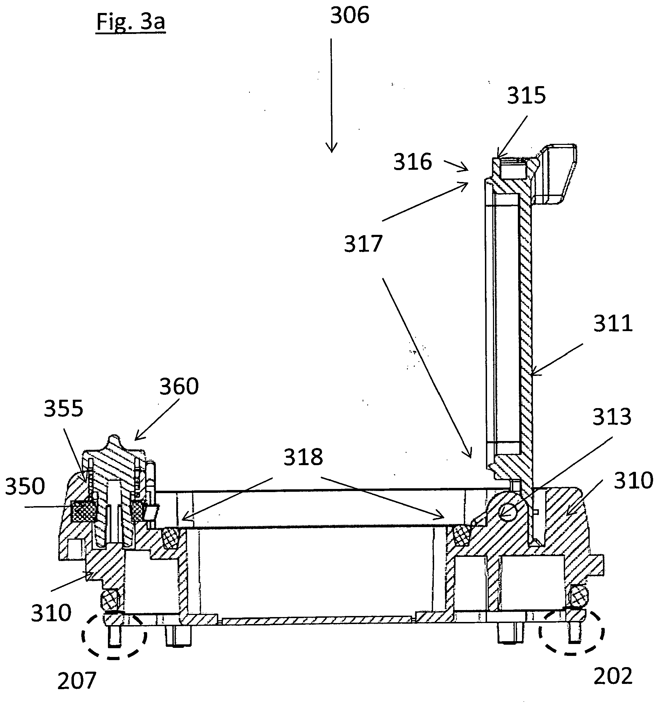

Die Fig. 3a bis 3e zeigen im Rahmen der Erfindung verschiedene, teilweise geschnittene Ansichten einer mit zweiten Kodierungsmitteln ausgestatteten weiteren Einbauplatte 306 mit einem Rahmen 310, in welchem eine Betätigungsklappe 311 schwenkbeweglich sowie ein Sperrmechanismus und ein Verschlussmechanismus, die mit der Betätigungsklappe zusammenwirkenden, angeordnet sind, wobei der Sperrmechanismus bevorzugt eine Aktivierung des Verschlussmechanismus verhindert, solange die Betätigungsklappe geöffnet ist.

Gemäß z.B. Fig. 3a sind an der Einbauplatte stiftartige Verlängerungen als Teil der zweiten Kodierungsmittel z.B. an den in Bezug auf die Einbauöffnung 101 entsprechenden gleichen vorbestimmten Positionen 202 und 207 (Fig. 3a) zu erkennen. Die dargestellte Betätigungsklappe kann zur Ausbildung eines Fensters 312 teilweise aus transparentem Material bestehen.

Der Verschlussmechanismus umfasst bei der dargestellten Ausführungsform zwei Scheiben 350, die jeweils an einem Drehhebel 360 und mit diesem drehbar angeordnet und in Bezug auf den geschlossen Zustand der Betätigungsklappe im Wesentlichen parallel zu dieser ausgerichtet sind. Für jede dieser Scheiben weist die Betätigungsklappe eine Aufnahme 314 auf, in welche der Verschlussmechanismus zum Schließen der Betätigungsklappe eingreifen kann. Bei der dargestellten Ausführungsform (Fig. 3a) sind die Aufnahmen 314 an der zur Schwenkachse 313 gegenüberliegenden Seite, zu welcher auch der Verschlussmechanismus benachbart am Rahmen ausgebildet ist.

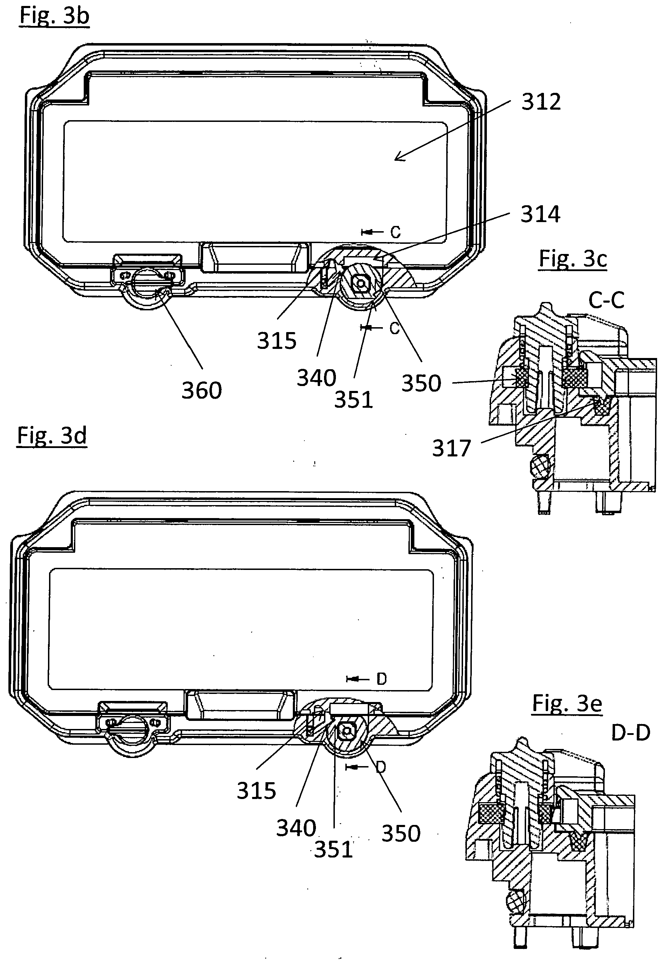

Jede der Scheiben 350 weist ein ausgespartes Segment aus, so dass in einer Drehstellung der Scheiben jeweils das ausgesparte Segment in Richtung der Aufnahme weist und also die Scheiben nicht in die Aufnahmen 314 eingreifen können (Fig. 3d) und in einer weiteren Drehstellung der Scheiben 350 jeweils die dem ausgesparten Segment gegenüberliegende Seite der Scheibe in Richtung der Aufnahmen weist und also die Scheiben 350 in die Aufnahmen 314 eingreifen können.

Die Aufnahmen 314 sind ferner jeweils durch eine Seitenfläche 315 sowie durch eine im geschlossenen Zustand in Richtung der Einbauöffnung blickende Außenfläche 316 begrenzt. An der, im geschlossenen Zustand in Richtung Einbauöffnung blickenden Unterseite der Betätigungsklappe ist zweckmäßig ein Vorsprung 317 ausgebildet, der im geschlossenen Zustand in eine am Rahmen angeordnete Dichtung 318 pressbar ist. Sowohl der Vorsprung 317 als auch die Dichtung 318 verlaufen bevorzugt rundherum.

Der Sperrmechanismus umfasst bei der dargestellten Ausführungsform zwei am Rahmen angelenkte Vorsprünge 340, wobei jeder der Vorsprünge in einen arretierten Zustand bringbar ist, in dem eine Sperrwirkung des Vorsprungs 340 deaktiviert ist und in einen ausgeschwenkten Zustand bringbar ist, in dem die Sperrwirkung des Vorsprungs 340 aktiviert ist. Jeder der Vorsprünge 340 ist hierbei benachbart zu einer Scheibe 350 derart am Rahmen angelenkt, dass jeder Vorsprung 340 im arretierten Zustand in eine am Umfang der Scheibe 350 ausgebildeten Nut 351 eingreift (Fig. 3d) und jeder Vorsprung 340 im verschwenkten Zustand aus dieser am Umfang der Scheibe 350 ausgebildeten Nut 351 herausgedrückt ist (Fig. 3b).
Die Nut 351 ist hierzu an einer Position am Umfang der Scheibe 350 ausgebildet, sodass im arretierten Zustand der Vorsprünge 340 jeweils das ausgesparte Segment in Richtung der Aufnahme 314 weist und also die Scheiben nicht in die Aufnahmen 314 eingreifen können (Fig. 3d). Da die Vorsprünge 340 im verschwenkten Zustand aus der am Umfang der Scheibe 350 ausgebildeten Nut 351 herausgedrückt sind (Fig. 3b) kann der Drehhebel 360 grundsätzlich gedreht werden, und zwar bis zu der Drehstellung der Scheiben 350, in welcher jeweils die dem ausgesparten Segment gegenüberliegende Seite einer Scheibe in Richtung der Aufnahmen weist. Ist die Betätigungsklappe geschlossen, können also die Scheiben 350 in die Aufnahmen 314 eingreifen, wobei hierbei ferner der Vorsprung 317 in die Dichtung 318 gepresst wird. Zum Unterstützen eines einfacheren Eingreifens der Scheiben 350 in die Aufnahmen 314 und eines wirkungsvolleren Pressens des Vorsprungs 317 in die Dichtung 318 können die Scheiben 350 sich radial nach außen hin verjüngend ausgebildet sein und/oder an der Ober- und/oder Unterseite eine Steigung aufweisen, die eine Art Schraubengang definieren.

Um die Vorsprünge 340 wieder in den arretierten Zustand zu bringen, wird der Drehhebel 360 wieder in die gegensätzliche Richtung gedreht, bis jeder Vorsprung 340 in die zugeordnete Nut 351 eingreift. Vorzugsweise sind die Drehhebel 360 im arretierten Zustand der Vorsprünge 340 vorgespannt und im verschwenkten Zustand gegenüber dem arretierten zustand entspannter, z.B. mittels eines Federmittel 355, das z.B. einerseits am Drehhebel 360 befestigten, um diesen herumgelenkten und andererseits am Rahmen 310 befestigt sein kann.

Zweckmäßiger Weise sind ferner die Seitenflächen 315 der Aufnahmen 314 und die Vorsprünge 340 derart in Bezug zueinander angeordnet, dass die Seitenflächen 315 beim Schließen der Betätigungsklappe 311 zunächst auf die Vorsprünge 340 treffen, und diese verschenken, bis diese den verschwenkten Zustand eingenommen haben und also aus den Nuten 351 herausgedrückt sind (Fig. 3b). Der Drehhebel 360 ist somit drehbar, und wenn die Betätigungsklappe geschlossen ist, können somit die Scheiben 350 in die Aufnahmen 314 eingreifen. Die Federmittel 355 können hierbei die notwendige Drehung bewirken.

Ein bevorzugt ausgebildeter Sperr- und Verschlussmechanismus arbeitet somit folgendermaßen.

Im geöffneten Zustand der Betätigungsklappe (Fig. 3a) sind die Vorsprünge 350 im arretierten Zustand, wie z.B. auch in Fig. 3d zu sehen, so dass die ausgesparten Segmente der Scheiben 350 in Richtung der Aufnahmen 314 zeigen. Der Sperrmechanismus verhindert folglich eine Aktivierung des Verschlussmechanismus, solange die Betätigungsklappe geöffnet ist.

Beim Schließen der Betätigungsklappe treffen die Außenflächen 316 und/oder die Seitenflächen 315 auf den Vorsprung 340 und verschwenken diesen aus der Nut 351 heraus, wobei der Vorsprung 340 z.B. zur Seite getrieben wird.
Aufgrund der Federmittel wird der Drehhebel 360 aus dem vorgespannten Zustand in Richtung des entspannteren Zustandes gedreht, bis zu der bei Fig. 3b dargestellten Drehstellung der Scheiben 350, d.h. bis im vollständig geschlossenen Zustand der Betätigungsklappe die den ausgesparten Segmenten gegenüberliegende Seiten der Scheiben 350 in die Aufnahmen 314 eingreifen und hierbei ferner den Vorsprung 317 in die Dichtung 318 pressen (Fig. 3c).

Der Sperrmechanismus ist folglich ausgebildet, beim Verschwenken der Betätigungsklappe 311 zum Schließen der Betätigungsplatte den Verschlussmechanismus zu aktivieren, wobei der Verschlussmechanismus wiederum ausgebildet ist, im dann aktivierten Zustand die Betätigungsklappe 311 beim Schließen der Betätigungsplatte auf die Dichtung 318 zu drücken.

Zum Öffnen der Betätigungsklappe dient der Drehhebel 360 als Verstelleinrichtung, um bei noch geschlossener Betätigungsklappe 311 den Sperrmechanismus wieder zu aktivieren, und zwar zur Deaktivierung des Verschlussmechanismus (Fig. 3d und 3e), d.h. im beschriebenen Beispiel, bis die den ausgesparten Segmenten gegenüberliegenden Seiten der Scheiben 350 sich hierbei aus den Aufnahmen 314 herausgedreht und diese freigegeben haben, so dass die Betätigungsklappe 311 angehoben werden kann und der Vorsprung 340 wieder arretiert ist. Der Sperrmechanismus bleibt dann bei geöffneter Betätigungsklappe weiter aktiviert.

Es ist aus vorstehender Beschreibung ersichtlicht, dass eine Einbauplatte, die einen Rahmen aufweist, an welchem mittels eines Scharniergelenkes eine Betätigungsklappe schwenkbeweglich angeordnet ist und welcher einen mit der Betätigungsklappe zusammenwirkenden Verschlussmechanismus und einen Sperrmechanismus besitzt, wobei der Sperrmechanismus eine Aktivierung des Verschlussmechanismus verhindert, solange die Betätigungsklappe geöffnet ist, und/oder wobei der Sperrmechanismus durch eine an dem Rahmen ausgebildete Verstelleinrichtung bei geschlossener Betätigungsklappe zur Deaktivierung des Verschlussmechanismus zum Öffnen der Betätigungsklappe aktivierbar ist und bei geöffneter Betätigungsklappe aktiviert bleibt, auch für andere Gehäusebausätze für elektrische Einrichtungen, bei welchem der Gehäusebausatz einen Gehäuse-Grundkörper mit einer Anzahl von Einbauöffnungen enthält, geeignet sein kann.

### Bezugszeichenliste

- 10, 11: Verbindungsmitteln;
- 101, 102, 102a, 102b, 103, 104, 105, 106, 106a, 106b, 107, 108, 109, 110: Einbauöffnungen;
- 150, 152: Stege;
- 151, 153: alternative Stelle für Stege
- 201, 202, 203, 204, 205, 206, 207, 208, 209, 210: vorbestimmte Positionen;
- 301, 302, 303, 304, 305, 306: Einbauplatten;
- 310: Rahmen;
- 311: Betätigungsklappe;
- 312: Fensters;
- 313: Schwenkachse;
- 314: Aufnahme für Scheibe;
- 315: Seitenfläche;
- 316: Außenfläche;
- 317: Vorsprung;
- 318: Dichtung;
- 340: angelenkter Vorsprung;
- 350: Scheibe;
- 351: Nut;
- 355: Federmittel;
- 360: Drehhebel.

## Patentansprüche

1. Gehäusebausatz für elektrische Einrichtungen enthaltend
- ein Gehäuse-Grundkörper mit einer Anzahl von Einbauöffnungen (101 - 110), und
- eine Anzahl von Einbauplatten (301 - 306), wobei
wenigstens eine Einbauplatte zur Eignung der Montage wenigstens einer Steckvorrichtung ausgebildet ist
und/oder
wenigstens eine Einbauplatte (306) wenigstens teilweise aus transparentem Material ist
und/oder
wenigstens eine Einbauplatte (301, 302, 303) vollständig geschlossen ist
und/oder
wenigstens eine Einbauplatte (304, 305) Lüftungsdurchgänge besitzt
und/oder
wenigstens eine Einbauplatte (306) einen Rahmen (310) aufweist, an welchem mittels eines Scharniergelenkes eine Betätigungsklappe (311) schwenkbeweglich angeordnet ist;
- wobei an jeder Einbauöffnung (101 - 110) ein erstes Codierungsmittel ausgebildet ist und an jeder Einbauplatte (301 - 306) ein zweites Codierungsmittel ausgebildet ist, **dadurch gekennzeichnet, dass**
- jedes erste Codierungsmittel einer Einbauöffnung (101 - 110) innerhalb des Gehäusebausatzes eine einzigartige erste Codierung und jedes zweite Codierungsmittel einer Einbauplatte (301 - 306) innerhalb des Gehäusebausatzes eine einzigartige zweite Codierung besitzt, derart, dass
- innerhalb des Gehäusebausatzes jedes zweite Codierungsmittel einer Einbauplatte (301 - 306) zu maximal einem ersten Codierungsmittel einer Einbauöffnung (101 - 110) komplementär ausgebildet ist, und
- zumindest innerhalb des Gehäusebausatzes jedes zweite Codierungsmittel einer Einbauplatte, welche wenigstens teilweise aus transparentem Material ist, zu einem ersten Codierungsmittel einer anderen Einbauöffnung (101 - 110) komplementär ausgebildet ist, als jedes zweite Codierungsmittel einer Einbauplatte, welche zur Eignung der Montage wenigstens einer Steckvorrichtung ausgebildet ist.

2. Gehäusebausatz nach Anspruch 1,
- wobei innerhalb des Gehäusebausatzes jedes erste Codierungsmittel einer Einbauplatte (301 - 306) zu maximal einem zweiten Codierungsmittel einer Einbauöffnung (101 - 110) komplementär ausgebildet ist, so dass innerhalb des Gehäusebausatzes in jede der Anzahl der Einbauöffnungen (101 - 110) nur eine einzige Einbauplatte (301 - 306) aus der Anzahl der Einbauplatten (301 - 306) montierbar ist.

3. Gehäusebausatz nach einem der vorstehenden Ansprüche, enthaltend
- zwei verschieden ausgestaltete Gehäuse-Grundkörper, die jeweils wenigstens eine Einbauöffnung (101 - 110) mit jeweils einem ersten daran ausgebildeten Codierungsmittel aufweisen, wobei jedes erstes Codierungsmittel innerhalb des Gehäusebausatzes einzigartig ist;
- eine Anzahl von Einbauplatten (301 - 306) mit jeweils einem daran ausgebildeten zweiten Codierungsmittel, wobei jedes zweite Codierungsmittel einer Einbauplatte (301 - 306) innerhalb des Gehäusebausatzes eine einzigartige zweite Codierung besitzt, derart, dass jedes zweite Codierungsmittel einer Einbauplatte (301 - 306) innerhalb des Gehäusebausatzes zu maximal einem ersten Codierungsmittel einer Einbauöffnung (101 - 110) komplementär ausgebildet ist, so dass innerhalb des Gehäusebausatzes jede der Anzahl der Einbauplatten (301 - 306) nur in eine einzige Einbauöffnung (101 - 110) montierbar ist.

4. Gehäusebausatz nach einem der vorstehenden Ansprüche, wobei der Rahmen (310) wenigstens einer Einbauplatte (306), die einen Rahmen (310) aufweist, an welchem eine Betätigungsklappe (311) schwenkbeweglich angeordnet ist, einen mit der Betätigungsklappe (311) zusammenwirkenden Verschlussmechanismus (350) und einen Sperrmechanismus (340) besitzt, wobei der Sperrmechanismus (340) eine Aktivierung des Verschlussmechanismus (350) verhindert, solange die Betätigungsklappe (311) geöffnet ist.

5. Gehäusebausatz nach vorstehendem Anspruch, wobei die Betätigungsklappe (311) ferner eine Dichtung (318) umfasst und der Sperrmechanismus (340) ausgebildet ist, beim Verschwenken der Betätigungsklappe (311) zum Schließen der Betätigungsplatte (311) den Verschlussmechanismus (350) zu aktivieren, wobei der Verschlussmechanismus (350) ausgebildet ist, im aktivierten Zustand die Betätigungsklappe (311) beim Schließen der Betätigungsplatte (311) auf die Dichtung (318) zu drücken.

6. Gehäusebausatz nach einem der vorstehenden Ansprüche 4 oder 5, wobei der Sperrmechanismus (340) durch an eine an dem Rahmen ausgebildete Verstelleinrichtung (360) bei geschlossener Betätigungsklappe (311) aktivierbar ist und zwar zur Deaktivierung des Verschlussmechanismus (350) zum Öffnen der Betätigungsklappe (311), wobei der
Sperrmechanismus (340) bei geöffneter Betätigungsklappe (311) aktiviert bleibt.

7. Gehäusebausatz nach einem der vorstehenden Ansprüche, wobei die Einzigartigkeit der ersten Codierungsmittel und die Einzigartigkeit der zweiten Codierungsmittel durch unterschiedliche Größen der Einbauöffnungen (101 - 110) bzw. der Einbauplatten (301 - 306) bereitgestellt ist.

8. Gehäusebausatz nach einem der vorstehenden Ansprüche, wobei die Einzigartigkeit der ersten Codierungsmittel und die Einzigartigkeit der zweiten Codierungsmittel durch unterschiedliche Formen der Einbauöffnungen (101 - 110) bzw. der Einbauplatten (301 - 306) bereitgestellt ist.

9. Gehäusebausatz nach einem der vorstehenden Ansprüche, wobei die Einzigartigkeit der ersten Codierungsmittel durch Ausbildung von an jeder Einbauöffnung (101 - 110) einzigartig angeordneten (201 - 210) stiftartigen Verlängerungen oder von Aufnahmen zur Aufnahme von stiftartigen Verlängerungen bereitgestellt ist und die Einzigartigkeit der zweiten Codierungsmittel durch in Bezug auf die ersten Codierungsmittel komplementäre Ausbildung von an jeder Einbauplatte (301 - 306) einzigartig ausgebildeten (201 - 210) Aufnahmen zur Aufnahme von stiftartigen Verlängerungen oder stiftartigen Verlängerungen.

10. Gehäusebausatz nach einem der vorstehenden Ansprüche, wobei der Gehäusegrundkörper wenigstens ein Gehäuseoberteil und ein Gehäuseunterteil besitzt, die reversibel miteinander verbindbar sind, und wobei das Gehäuseoberteil mit wenigstens einer solchen Einbauöffnung (101 - 110) ausgebildet ist.

11. Gehäusebausatz nach einem der vorstehenden Ansprüche, wobei der Gehäusegrundkörper wenigstens ein Gehäuseoberteil und ein Gehäuseunterteil besitzt, die reversibel miteinander verbindbar sind, und wobei das Gehäuseunterteil mit wenigstens einer solchen Einbauöffnung (101 - 110) ausgebildet ist.

12. Gehäusebausatz für elektrische Einrichtungen nach einem der vorstehenden Ansprüche, wobei die elektrischen Einrichtungen wenigstens eine Steckvorrichtung und/oder eine Sicherung umfassen.

13. Einbauplatte (306) für einen Gehäusebausatz für elektrische Einrichtungen, bei welchem der Gehäusebausatz einen Gehäuse-Grundkörper mit einer Anzahl von Einbauöffnungen (101 - 110) nach einem der vorstehenden Ansprüche enthält, die einen Rahmen (310) aufweist, an welchem mittels eines Scharniergelenkes eine Betätigungsklappe (311) schwenkbeweglich angeordnet ist und welcher einen mit der Betätigungsklappe (311) zusammenwirkenden Verschlussmechanismus (350) und einen Sperrmechanismus (340) besitzt, wobei der Sperrmechanismus eine Aktivierung des Verschlussmechanismus (350) verhindert, solange die Betätigungsklappe (311) geöffnet ist und/oder wobei der Sperrmechanismus (340) durch eine an dem Rahmen ausgebildete Verstelleinrichtung (360) bei geschlossener Betätigungsklappe (311) zur Deaktivierung des Verschlussmechanismus (350) zum Öffnen der Betätigungsklappe (311) aktivierbar ist und bei geöffneter Betätigungsklappe (311) aktiviert bleibt.

14. Einbauplatte nach Anspruch 13, wobei die Betätigungsklappe (311) ferner eine Dichtung (318) umfasst und der Sperrmechanismus (340) ausgebildet ist, beim Verschwenken der Betätigungsklappe zum Schließen der Betätigungsplatte (311) den Verschlussmechanismus (350) zu aktivieren, wobei der Verschlussmechanismus (350) ausgebildet ist, im aktivierten Zustand die Betätigungsklappe (311) beim Schließen der Betätigungsplatte (311) auf die Dichtung (318) zu drücken.

## Claims

1. A housing construction set for electrical devices, comprising:
- a housing basic body having a number of installation openings (101-110); and
- a number of installation plates (301 - 306), wherein
at least one installation plate is adapted to be suitable for mounting at least one plug-in device; and/or
at least one installation plate (306) is at least partially made of transparent material; and/or
at least one installation plate (301, 302, 303) is completely closed; and/or
at least one installation plate (304, 305) has ventilation passages; and/or
at least one installation plate (306) has a frame (310) on which an operating flap (311) is pivotably mounted by means of a hinge joint;
- wherein a first coding means is formed at each installation opening (101 - 110) and a second coding means is formed on each installation plate (301 - 306); **characterized in that**
- each first coding means of an installation opening (101 - 110) has a first coding that is unique in the housing construction set, and each second coding means of an installation plate (301 - 306) has a second coding that is unique in the housing construction set, such that
- each second coding means of an installation plate (301 - 306) in the housing construction set is designed to be complementary to not more than a single first coding means of an installation opening (101 - 110); and
- at least in the housing construction set, each second coding means of an installation plate that is at least partially made of transparent material is designed to be complementary to a first coding means of a different installation opening (101 - 110) than each second coding means of an installation plate that is designed to be suitable for mounting at least one plug-in device.

2. The housing construction set according to claim 1,
- wherein each first coding means of an installation plate (301 - 306) in the housing construction set is designed to be complementary to not more than a single second coding means of an installation opening (101 - 110), so that only a single installation plate (301 - 306) of the number of installation plates (301 - 306) in the housing construction set can be installed in each of the number of installation openings (101 - 110).

3. The housing construction set according to any one of the preceding claims, comprising:
- two differently designed housing basic bodies, each one having at least one installation opening (101 - 110) with a first coding means formed thereon, wherein each first coding means is unique in the housing construction set;
- a number of installation plates (301 - 306), each one having a second coding means formed thereon, wherein each second coding means of an installation plate (301 - 306) in the housing construction set has a unique second coding in such a manner that each second coding means of an installation plate (301 - 306) in the housing construction set is designed to be complementary to not more than a single first coding means of an installation opening (101 - 110), so that each of the number of installation plates (301 - 306) in the housing construction set can be installed in only a single installation opening (101 - 110).

4. The housing construction set according to any one of the preceding claims, wherein the frame (310) of at least one installation plate (306) that has a frame (310) on which an operating flap (311) is pivotably mounted comprises a closure mechanism (350) cooperating with the operating flap (311), and a locking mechanism (340), wherein the locking mechanism (340) prevents activation of the closure mechanism (350) as long as the operating flap (311) is open.

5. The housing construction set according to the preceding claim, wherein the operating flap (311) further comprises a gasket (318), and wherein the locking mechanism (340) is adapted to activate the closure mechanism (350) when the operating flap (311) is pivoted to close the operating flap (311), wherein the closure mechanism (350) is adapted in its activated state to press the operating flap (311) onto the gasket (318) when the operating flap (311) is being closed.

6. The housing construction set according to any one of the preceding claims 4 or 5, wherein the locking mechanism (340) can be activated by an adjusting means (360) formed on the frame when the operating flap (311) is closed, and that for deactivating the closure mechanism (350) for opening the operating flap (311), with the locking mechanism (340) remaining activated when the operating flap (311) is open.

7. The housing construction set according to any one of the preceding claims, wherein the uniqueness of the first coding means and the uniqueness of the second coding means is provided through different sizes of the installation openings (101 - 110) and of the installation plates (301 - 306).

8. The housing construction set according to any one of the preceding claims, wherein the uniqueness of the first coding means and the uniqueness of the second coding means is provided through different shapes of the installation openings (101 - 110) and of the installation plates (301 - 306).

9. The housing construction set according to any one of the preceding claims, wherein the uniqueness of the first coding means is provided by having formed pin-like extensions arranged uniquely (201 - 210) at each installation opening (101 - 110), or by receptacles for receiving pin-like extensions, and wherein the uniqueness of the second coding means is provided by a complementary design, with respect to the first coding means, of receptacles for receiving pin-like extensions or of pin-like extensions formed uniquely (201 - 210) on each installation plate (301 - 306).

10. The housing construction set according to any one of the preceding claims, wherein the housing basic body comprises at least one housing upper part and one housing lower part, which are connectable to each other in reversible manner, and wherein the housing upper part is formed with at least one such installation opening (101 - 110).

11. The housing construction set according to any one of the preceding claims, wherein the housing basic body has at least one housing upper part and one housing lower part, which are connectable to each other in reversible manner, and wherein the housing lower part is formed with at least one such installation opening (101 - 110).

12. The housing construction set for electrical devices according to any one of the preceding claims, wherein the electrical devices comprise at least one plug-in device and/or one fuse-type device.

13. An installation plate for a housing construction set for electrical devices, wherein the housing construction set comprises a housing basic body with a number of installation openings (101 - 110) according to any one of the preceding claims, the installation plate comprising a frame (310) on which an operating flap (311) is pivotable mounted by means of a hinge joint, and which comprises a closure mechanism (350) cooperating with the operating flap (311), and a locking mechanism (340), wherein the locking mechanism (340) prevents activation of the closure mechanism (350) as long as the operating flap (311) is open, and/or wherein the locking mechanism (340) can be activated by an adjusting means (360) formed on the frame when the operating flap (311) is closed, for deactivating the closure mechanism (350) for opening the operating flap (311), and remains activated when the operating flap (311) is open.

14. The installation plate as claimed in claim 13, wherein the operating flap (311) further comprises a gasket (318), and wherein the locking mechanism (340) is adapted to activate the closure mechanism (350) when the operating flap is pivoted to close the operating flap (311), wherein the closure mechanism (350) is adapted in its activated state to press the operating flap (311) onto the gasket (318) when the operating flap (311) is being closed.

## Revendications

1. Ensemble boîtier pour des dispositifs électriques contenant :
- un corps de base de boîtier comprenant un certain nombre d'ouvertures de montage (101 - 110), et
- un certain nombre de plaques de montage (301 - 306), où :
au moins une plaque de montage est réalisée de manière appropriée pour le montage d'au moins un dispositif de connexion,
et/ou
au moins une plaque de montage (306) est au moins en partie composée de matériau transparent,
et/ou
au moins une plaque de montage (301, 302, 303) est entièrement fermée,
et/ou
au moins une plaque de montage (304, 3045) possède des passages de ventilation,
et/ou
au moins une plaque de montage (304, 306) comprend un cadre (310) sur lequel un volet d'actionnement (311) est agencé de manière à pouvoir se déplacer par pivotement au moyen d'une articulation à charnière ;
- dans lequel un premier moyen de codification est réalisé sur chaque ouverture de montage (101 - 110) et un deuxième moyen de codification est réalisé sur chaque plaque de montage (301 - 306), **caractérisé en ce que** :
- chaque premier moyen de codification d'une ouverture de montage (101 - 110) à l'intérieur de l'ensemble boîtier porte une première codification unique et chaque deuxième moyen de codification d'une plaque de montage (301 - 306) à l'intérieur de l'ensemble boîtier porte une deuxième codification unique, de telle manière que :
- à l'intérieur de l'ensemble boîtier, chaque deuxième moyen de codification d'une plaque de montage (301 - 306) est réalisé pour être complémentaire au maximum à un premier moyen de codification d'une ouverture de montage (101 - 110), et
- au moins à l'intérieur de l'ensemble boîtier, chaque deuxième moyen de codification d'une plaque de montage, laquelle est composée au moins en partie de matériau transparent, est réalisé pour être complémentaire au maximum à un premier moyen de codification d'une autre ouverture de montage (101 - 110), autre que celle correspondant à tout autre deuxième moyen de codification d'une plaque de montage, laquelle est réalisée de manière appropriée pour le montage d'au moins un dispositif de connexion.

2. Ensemble boîtier selon la revendication 1, dans lequel, à l'intérieur de l'ensemble boîtier, chaque premier moyen de codification d'une plaque de montage (301 - 306) est réalisé pour être complémentaire au maximum à un deuxième moyen de codification d'une ouverture de montage (101 - 110), de sorte qu'à l'intérieur de l'ensemble boîtier, une seule plaque de montage (301 - 306) du certain nombre de plaques de montage (301 - 306) peut être montée dans chaque ouverture du certain nombre d'ouvertures de montage (101 - 110).

3. Ensemble boîtier selon l'une quelconque des revendications précédentes, contenant :
- deux corps de base de boîtier présentant une configuration différente, qui comprennent chacun au moins une ouverture de montage (101 - 110) sur chacune desquelles un premier moyen de codification est réalisé, chaque premier moyen de codification à l'intérieur de l'ensemble boîtier étant unique ;
- un certain nombre de plaques de montage (301 - 306) sur chacune desquelles un deuxième moyen de codification est réalisé, chaque deuxième moyen de codification d'une plaque de montage (301 - 306) portant à l'intérieur de l'ensemble boîtier une deuxième codification unique, de telle manière que chaque deuxième moyen de codification d'une plaque de montage (301 - 306), à l'intérieur de l'ensemble boîtier, est réalisé pour être complémentaire au maximum à un moyen de codification d'une ouverture de montage (101 - 110), de sorte qu'à l'intérieur de l'ensemble boîtier, chaque plaque du certain nombre de plaques de montage (301 - 306) ne peut être montée que dans une seule ouverture de montage (101 - 110).

4. Ensemble boîtier selon l'une quelconque des revendications précédentes, dans lequel le cadre (310) d'au moins une plaque de montage (306), qui comprend un cadre (310) sur lequel un volet d'actionnement (311) est agencé de manière à pouvoir se déplacer par pivotement, possède un mécanisme de fermeture (350) coopérant avec le volet d'actionnement (311) et un mécanisme de verrouillage (340), dans lequel le mécanisme de verrouillage (340) empêche une activation du mécanisme de fermeture (350) tant que le volet d'actionnement (311) est ouvert.

5. Ensemble boîtier selon l'une quelconque des revendications précédentes, dans lequel le volet d'actionnement (311) comprend en outre un joint (318) et le mécanisme de verrouillage (340) est conçu pour activer le mécanisme de fermeture (350) lors du pivotement du volet d'actionnement (311) pour fermer la plaque d'actionnement (311), dans lequel le mécanisme de fermeture (350) est conçu, dans l'état activé, pour presser le volet d'actionnement (311) sur le joint (318) lors de la fermeture de la plaque d'actionnement (311).

6. Ensemble boîtier selon l'une quelconque des revendications 4 et 5, dans lequel le mécanisme de verrouillage (340) peut être activé par un dispositif de réglage (360) réalisé sur le cadre, lorsque le volet d'actionnement (311) est fermé, et ce pour désactiver le mécanisme de fermeture (350) et ouvrir le volet d'actionnement (311), dans lequel le mécanisme de verrouillage (340) reste activé lorsque le volet d'actionnement (311) est ouvert.

7. Ensemble boîtier selon l'une quelconque des revendications précédentes, dans lequel le caractère unique des premiers moyens de codification et le caractère unique des deuxièmes moyens de codification sont assurés par une différence de taille des ouvertures de montage (101 - 110) ou des plaques de montage (301 - 306).

8. Ensemble boîtier selon l'une quelconque des revendications précédentes, dans lequel le caractère unique des premiers moyens de codification et le caractère unique des deuxièmes moyens de codification sont assurés par une différence de forme des ouvertures de montage (101 - 110) ou des plaques de montage (301 - 306).

9. Ensemble boîtier selon l'une quelconque des revendications précédentes, dans lequel le caractère unique des premiers moyens de codification est assuré par la réalisation de prolongements en forme de tige (201 - 210) agencés de façon unique sur chaque ouverture de montage (101 - 110) ou de logements servant à loger les prolongements en forme de tige et le caractère unique des deuxièmes moyens de codification est assuré par la réalisation, complémentaire par rapport au premier moyen de codification, de logements (201 - 210) réalisés de façon unique sur chaque plaque de montage (301 - 306) et servant à loger des prolongements du type tige, ou de prolongements du type tige.

10. Ensemble boîtier selon l'une quelconque des revendications précédentes, dans lequel le corps de base du boîtier possède au moins une partie supérieure de boîtier et une partie inférieure de boîtier, qui peuvent être reliées l'une à l'autre de manière réversible, et dans lequel la partie supérieure du boîtier est pourvue d'au moins une telle ouverture de montage (101 - 110).

11. Ensemble boîtier selon l'une quelconque des revendications précédentes, dans lequel le corps de base du boîtier possède au moins une partie supérieure de boîtier et une partie inférieure de boîtier qui peuvent être reliées l'une à l'autre de manière réversible, et dans lequel la partie inférieure du boîtier est pourvue d'au moins une telle ouverture de montage (101 - 110).

12. Ensemble boîtier pour des dispositifs électriques selon l'une quelconque des revendications précédentes, dans lequel les dispositifs électriques comportent au moins un dispositif de connexion et/ou un dispositif de sécurité.

13. Plaque de montage (306) destinée à un ensemble boîtier pour des dispositifs électriques, l'ensemble boîtier contenant un corps de base de boîtier présentant un certain nombre d'ouvertures de montage (101 - 110) selon l'une quelconque des revendications précédente, qui comprend un cadre (310) sur lequel un volet d'actionnement (311) est agencé de manière à pouvoir se déplacer par pivotement au moyen d'une articulation à charnière et lequel possède un mécanisme de fermeture (350) coopérant avec le volet d'actionnement (311) et un mécanisme de verrouillage (340), le mécanisme de verrouillage empêchant une activation du mécanisme de fermeture (350) tant que le volet d'actionnement (311) est ouvert et/ou le mécanisme de verrouillage (340) pouvant être activé par un dispositif de réglage (360) réalisé sur le cadre lorsque le volet d'actionnement (311) est fermé pour désactiver le mécanisme de fermeture (350) et ouvrir le volet d'actionnement (311), et restant activé lorsque le volet d'actionnement (311) est ouvert.

14. Plaque de montage selon la revendication 13, le volet d'actionnement (311) comprenant en outre un joint (318) et le mécanisme de verrouillage (340) étant conçu pour activer le mécanisme de fermeture (350) pour fermer la plaque d'actionnement (311) lors du pivotement du volet d'actionnement, le mécanisme de fermeture (350) étant conçu, dans l'état activé, pour presser le volet d'actionnement (311) sur le joint (318) lors de la fermeture de la plaque d'actionnement (311).
